# EUROPÄISCHE PATENTSCHRIFT

(11) **EP 1 831 437 B1**
(45) Veröffentlichungstag und Bekanntmachung des Hinweises auf die Patenterteilung: **21.04.2010**
(21) Anmeldenummer: 05815830.4
(22) Anmeldetag: 12.12.2005
(51) Int. Cl.: C30B 25/10, C23C 16/46

(54) **CVD-REAKTOR MIT RF-GEHEIZTER PROZESSKAMMER**
CVD REACTOR COMPRISING AN RF-HEATED TREATMENT CHAMBER
REACTEUR CVD AYANT UNE CHAMBRE DE TRAITEMENT CHAUFFEE PAR RF

(30) Priorität: 24.12.2004 DE 102004062553
(43) Veröffentlichungstag der Anmeldung: 12.09.2007
(73) Patentinhaber: AIXTRON AG, 52134 Herzogenrath (DE)
(72) Erfinder: KÄPPELER, Johannes, 52146 Würselen (DE); WISCHMEYER, Frank, 49326 Melle (DE)
(74) Vertreter: Grundmann, Dirk
(86) Internationale Anmeldenummer: PCT/EP2005/056679
(87) Internationale Veröffentlichungsnummer: WO 2006/069908

(56) Entgegenhaltungen:
- WO-A-00/43577
- WO-A-2004/053187
- DE-A1- 10 055 182
- US-A- 5 433 167
- US-B1- 6 299 683

## Beschreibung

Die Erfindung betrifft eine Vorrichtung zum Abscheiden insbesondere kristalliner Schichten auf mindestens einem insbesondere kristallinen Substrat, mit einer von mehreren Wandungsteilen gebildeten Prozesskammer, welche Wandungsteile elektrisch leitend sind und unter Ausbildung von Berührungskontakten aneinander stoßen, mit einem die Prozesskammerwandungsteile in sich aufnehmenden, aus einem elektrisch nicht leitenden Material bestehenden Reaktorgehäuse und mit einer die Prozesskammerwandungsteile umgebenden RF-Heiz-Spule.

Eine derartige Vorrichtung wird von der DE 10055182 A1 beschrieben. Diese Vorrichtung besteht aus einem Quarzrohr, innerhalb welchem sich eine Prozesskammer befindet. Die Prozesskammerwandung besteht aus mehreren Graphitteilen, nämlich einer Decke, zwei Wänden und einem Boden. Die einzelnen Graphit-Wandungsteile stoßen berührend aneinander. Die bekannte Vorrichtung ist von einer RF-Spule umgeben, die innerhalb des Reaktorgehäuses ein RF-Feld erzeugt. Letzteres erzeugt in den Prozesskammerwandungen Wirbelströme. Zufolge der Kontaktwiderstände in den Bereichen, wo die einzelnen Wandungsteile aneinander stoßen, können dort lokale Erwärmungen oder sogar Funkenüberschläge stattfinden. Aus der WO00/43577 ist eine Vorrichtung zum Abscheiden von SiC bekannt, bei dem das Reaktorgehäuse aus einem Quarzrohr mit sich in einem Punkt kreuzenden Rohrflanschen besteht. Innerhalb des Quarzrohres befindet sich ein komplexer Graphitkörper, der von außen mit einem RF-Feld beheizt wird. Innerhalb des Graphitkörpers befindet sich die Prozesskammer, deren Wandung von miteinander verbundenen Tantalstreifen gebildet ist.

Der Erfindung liegt die Aufgabe zugrunde, eine gattungsgemäße Vorrichtung dahingehend weiterzubilden, dass das Temperaturprofil innerhalb der Prozesskammer homogener ist.

Gelöst wird die Aufgabe durch die in den Ansprüchen angegebene Erfindung

Der Anspruch 1 sieht zunächst und im Wesentlichen ein Schirm-Heiz-Rohr vor Dieses Rohr soll innerhalb des Reaktorgehäuses, aber außerhalb der Prozesskammer angeordnet sein und derart elektrisch leitend sind, dass das von der RF-Spule erzeugte RF-Feld dort Wirbelströme erzeugt. Diese Wirbelströme sollen das Schirm-Heiz-Rohr erwärmen und gleichzeitig die Feldstärke des RF-Feldes derart dämpfen, dass in den elektrisch leitenden Wänden der Prozesskammer nur ein Bruchteil der Wirbelströme induziert wird, wie es beim Stand der Technik der Fall ist, so dass die Erwärmung im Wesentlichen im Material des Schirm-Heiz-Rohres stattfindet. Dies hat zur Folge, dass die beim Stand der Technik beobachteten lokalen Erwärmungen im Bereich der Berührungszonen der einzelnen Prozesskammerwandteile verhindert werden. Als Folge davon ergibt sich ein homogenisiertes Temperaturprofil innerhalb der Prozesskammer des Heißwandreaktors. In einer Weiterbildung der Erfindung ist vorgesehen, dass das Schirm-Heiz-Rohr aus Graphit besteht. Es ist einteilig und massiv. Das Rohr ist beispielsweise durch Bohren eines Vollmaterialteiles, welches zuvor auf eine Zylinderform gedreht worden ist, fertigbar. Die Wandstärke des Schirm-Heiz-Rohres ist so gewählt, dass der erforderliche Abschirmeffekt eintritt. Außerdem besitzt die Innenwandung des Schirm-Heiz-Rohres vorzugsweise eine Profilierung, mittels welcher die Prozesskammer innerhalb des Schirm-Heiz-Rohres gehalten werden kann. Diese Haltemittel können sowohl Kerbaussparungen als auch Vorsprünge sein, die von der Innenwandung des Schirm-Heiz-Rohres radial einwärts ragen. Oberhalb der Prozesskammerdecke und unterhalb des Prozesskammerbodens befindet sich zwischen der Prozesskammerwandung einerseits und dem Schirm-Heiz-Rohr andererseits jeweils eine Höhlung. Diese Höhlung kann zur Kühlung der gesamten Vorrichtung verwendet werden, wenn der chemische Abscheidungsprozess beendet ist. Die Kühlung kann beispielsweise durch Einleiten eine kalten Gases bewirkt werden. Es ist aber auch vorgesehen, dass Festkörper mit geeigneten Kühlflüssigkeiten in diese Höhlungen zur Kühlung eingebracht werden. In einer Weiterbildung der Erfindung ist vorgesehen, dass der Prozesskammerboden eine entnehmbare Ladeplatte besitzt, die einen Substrathalter trägt, auf welchem das zu beschichtende Substrat aufliegt. Hinsichtlich der Ausgestaltung einer derartigen Ladeplatte wird auf die DE 10055182 A1 verwiesen, deren Offenbarungsgehalt voll in die vorliegende Anmeldung einbezogen wird. So ist insbesondere vorgesehen, dass im Boden der Prozesskammerwandung ein Strömungskanal verläuft, durch welchen ein Trägergas eingeleitet wird, welches in Austrittsdüsen unterhalb des Substrathalters austritt, um ein sich drehendes Gaspolster für den Substrathalter zu erzeugen.

Ausführungsbeispiele der Erfindung werden nachfolgend anhand beigefügter Zeichnungen erläutert. Es zeigen:
- Fig.1: den Querschnitt durch ein Reaktorgehäuse eines ersten Ausführungsbeispiels,
- Fig. 2: den Querschnitt durch ein Reaktorgehäuse eines zweiten Ausführungsbeispiels,

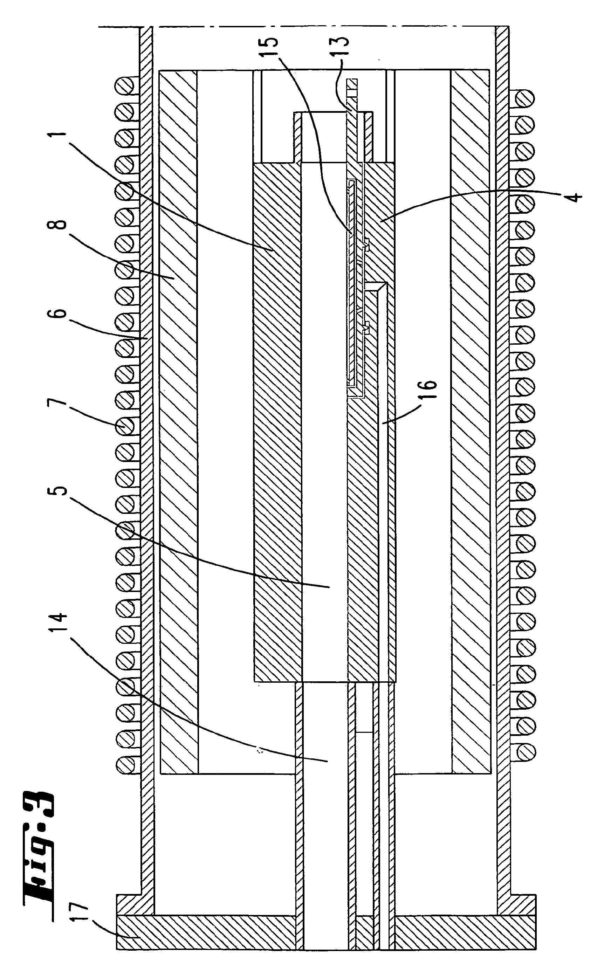

- Fig. 3: einen Schnitt gemäß der Linie III-III in Fig. 1,
- Fig. 4: ein weiteres Ausführungsbeispiel der Erfindung in einer Darstellung gemäß Fig. 1, und
- Fig. 5: ein Detail gemäß Ausschnitt V in Fig. 4.

Bei den in den Ausführungsbeispielen beschriebenen Vorrichtungen handelt es sich um CVD-Reaktoren, die eine Prozesskammer 5 aufweisen, innerhalb derer ein Abscheidungsprozess abläuft. Es handelt sich um CVD-Reaktoren zum Abscheiden von insbesondere III-V- oder II-VI- Halbleiterschichten auf III-V- oder II-VI- Substraten. Die reaktiven Gase werden durch einen Gaseinlass 14 in die allseitig beheizte Prozesskammer 5 eingeleitet. Bei den reaktiven Gasen handelt es sich vorzugsweise im Metallchloride, beispielsweise Galliumchlorid oder Indiumchlorid bzw. Hydride, beispielsweise Arsin oder Phosphin. Durch eine pyrolytische Zerlegung innerhalb der Prozesskammer 5 wird auf dem Substrat eine kristalline Schicht abgeschieden. Zusätzlich werden geeignete Trägergase wie Wasserstoff oder Stickstoff in die Prozesskammer eingeleitet.

Es ist eine spezielle Gaszuleitung 16 vorgesehen, durch welche das Trägergas, beispielsweise Wasserstoff in den Boden 4 der Prozesskammer eingeleitet wird. Diese Gaszuleitung 16 mündet im Boden einer Stufe, auf welcher eine Ladeplatte 13. Die Mündung der Gaszuleitung 16 ist von einer ringförmigen Nut umgeben, in welche ein ringförmiger Dichtungsfortsatz des Bodens der Ladeplatte 13 ragt. Aus der dadurch entstehenden ringförmigen Kammer kann das dort durch die Gaszuleitung 16 einströmende Gas durch dünne Gasleitungen in eine Aussparung der Ladeplatte 13 treten, in welcher ein Substrathalter 15 liegt. Der Substrathalter 15 ist kreisförmig und trägt ein Substrat. Das unter dem Substrathalter 15 eingeleitete Gas bewirkt eine Drehung und ein Anheben des Substrathalters 15, so dass dieser auf einem Gaspolster schwebt.

Die Ladeplatte 13 kann mit geeigneten Handhabungsgerätschaften aus der Prozesskammer 5 entnommen werden. Details hierzu werden in der DE 10055182 A1 beschrieben.

Die Wandung der Reaktionskammer wird von einem Quarzrohr 6 gebildet. Dieses ist im Bereich des Gaseinlasses 14 mit einer Verschlussplatte 17 verschlossen. Gasauslassseitig ist eine ähnliche, nicht dargestellte Verschlussplatte vorgesehen.

Um das Quarzrohr 6 ist eine RF-Spule gewunden. Diese besteht aus einer Vielzahl von Windungen, die axial hintereinander liegen, so dass ein Axialabschnitt der Prozesskammer im Bereich des von der RF-Spule 7 erzeugten Hochfrequenz-Feldes liegt.

Nahezu über die gesamte Länge der RF-Spule 7 erstreckt sich im Inneren des Quarzrohres 6 ein Graphitrohr 8. Dieses Graphitrohr 8 bildet ein Schirm-Heiz-Rohr. In ihm erzeugt das RF-Feld der RF-Spule Wirbelströme, so dass sich das Graphitrohr 8 aufheizt. Das Graphitrohr 8 bewirkt darüber hinaus eine Dämpfung des RF-Feldes derart, dass in den Prozesskammerwandungsteilen 1, 2, 3, 4 nur geringe Wirbelströme induziert werden, so dass die Prozesskammer insgesamt im Wesentlichen durch Wärmestrahlung aufgeheizt wird, wobei die Strahlungswärme vom Schirm-Heiz-Rohr kommt.

Die Prozesskammer 5 ist umgeben von einer oberen Decke 1 und einem unteren Boden 4. Auf den Randabschnitten des Bodens 4 stehen Seitenteile 2,3, die formschlüssig mit dem Boden 4 bzw. der Prozesskammerdecke 1 verbunden sind. Federn der Seiten 2,3 greifen in entsprechende Nuten von Prozesskammerdecke 1 und Prozesskammerboden 4 ein. Diese Bereiche bilden Berührungskontaktzonen 2', 2", 3" und 3".

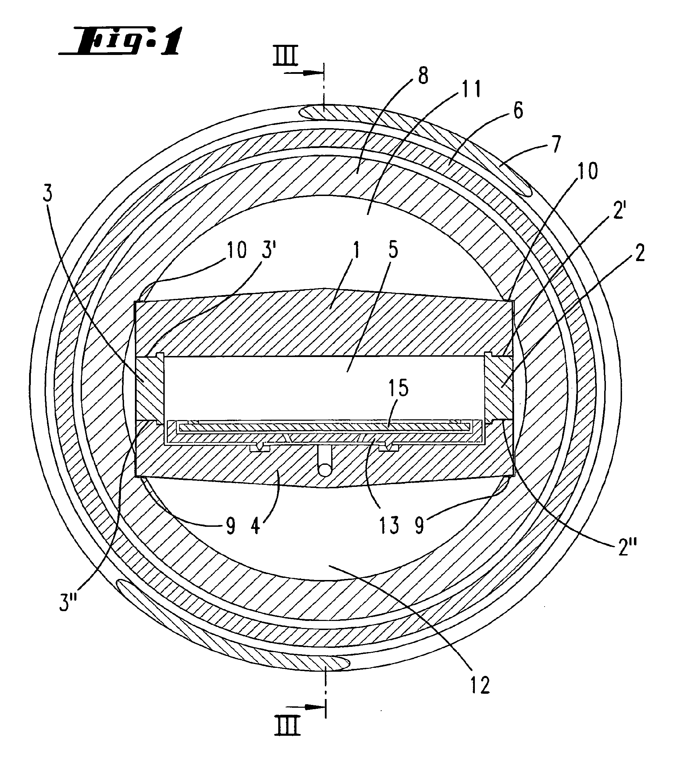

Bei dem in Fig.1 dargestellten Ausführungsbeispiel besitzt die Prozesskammer eine rechteckige Form, wobei ihre Breite erheblich größer ist als ihre Höhe. Die Eckbereiche des Bodens 4 liegen in Eckaussparungen 9 der Innenwandung des Schirm-Heiz-Rohres 8 ein. Diesen Eckaussparungen 9 liegen weitere Eckaussparungen 10 gegenüber, welche die Ecken der Prozesskammerdecke 1 umfassen. Die Prozesskämmerteile 1, 2, 3, 4 liegen mit ausreichendem Spiel in den Eckaussparungen 9, 10 ein, damit eine Wärmeausdehnung möglich ist.

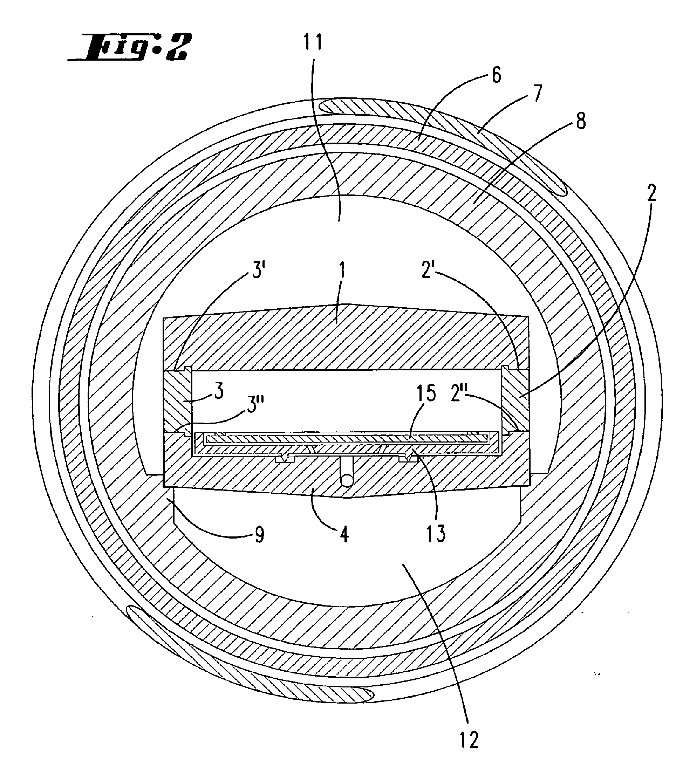

Bei dem in Fig. 2 dargestellt Ausführungsbeispiel ragen aus der Innenwandung des Schirm-Heiz-Rohres 8 Vorsprünge 9 ab, die ebenfalls Eckaussparungen ausbilden, in denen die Eckbereiche des Prozesskammerbodens 4 einliegen.

Wesentlich ist die radiale Dicke des aus Graphit bestehenden Schirm-Heiz-Rohres in Kombination mit seiner elektrischen Leitfähigkeit. Diese muss groß genug sein, damit eine genügend hohe Dämpfung erzielt ist, dass in den Berührungszonen 2', 2", 3', 3" keine hohen Spannungen erzeugt werden, die zu lokalen Erwärmungen führen könnten.

Von Vorteil sind ferner die beiden sich diametral gegentiberliegenden Höhlungen 11,12, die unterhalb des Bodens 4 bzw. oberhalb der Prozesskammerdecke 1 angeordnet sind. Diese Höhlungen 11, 12 können dazu benutzt werden, in der Abkühlphase Kühlkörper einzuführen. Diese Hohlräume können auch durch andersartige Kühlmedien durchströmt oder durchflossen werden. Im einfachsten Fall können von der Gasauslassseite oder der Gaseinlassseite in den Zeichnungen nicht dargestellte Kühlstäbe dort eingeführt werden. Diese Kühlstäbe können wassergekühlt sein, um schnell die Wärme aus dem Reaktor abzuführen.

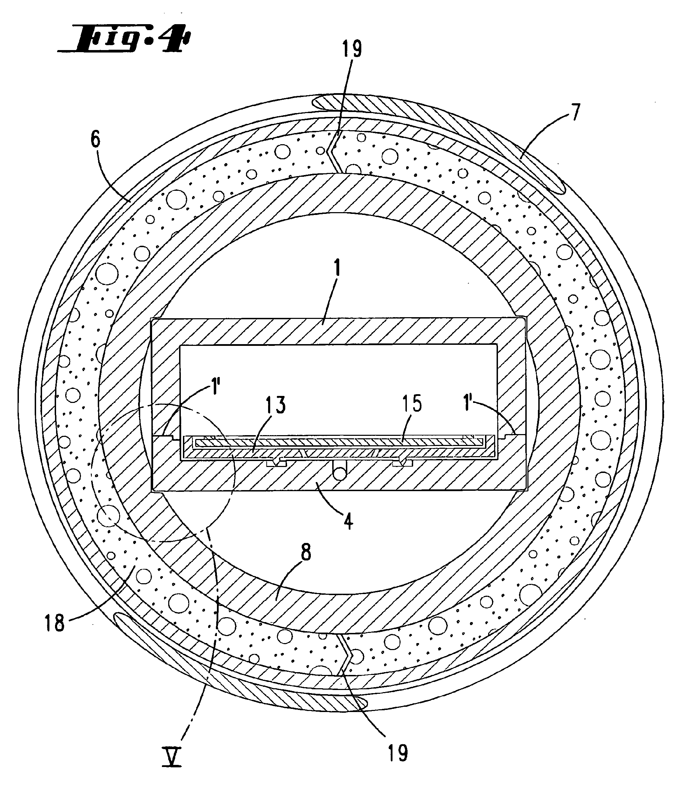

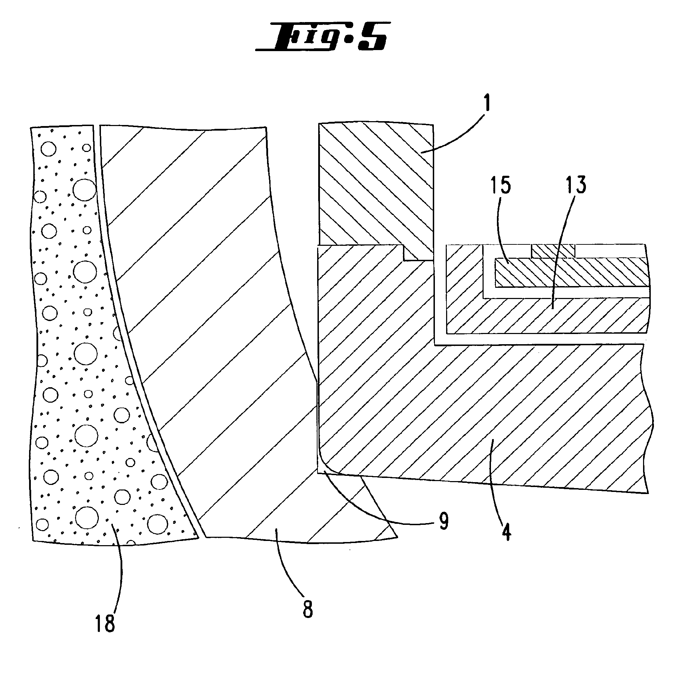

Bei dem in den Figuren 4 und 5 dargestellten Ausführungsbeispiel ist das Schirm-Heiz-Rohr 8 aus Graphit gefertigt und besitzt innenwandseitig winkelförmige Kehlen 9, die die unteren Randkanten des Bodens 4 der Prozesskammer aufnehmen. Die Prozesskammer ist hier zweiteilig ausgebildet. Auf den Rändern des Bodens 4 ruhen die profilierten Schenkel 1' eines U-förmigen, aus Graphit bestehenden Deckelteils 1.

Das Schirm-Heiz-Rohr 8 ist von einem Graphitschaum 18 umgeben. Dieser besitzt zwei sich diametral gegenüberliegende winkelförmige Dehnungsspalte 19. Der aus zwei Halbschalen bestehende Graphitschaumkörper 18 hält das Schirm-Heiz-Rohr 8 in einer koaxialen Lage zu dem aus Quarz bestehenden Reaktorgehäuserohr 6. Betreffend die Ausgestaltung des Graphitschaums wird auf die DE 10055182 A1 verwiesen.

Alle offenbarten Merkmale sind (für sich) erfindungswesentlich. In die Offenbarung der Anmeldung wird hiermit auch der Offenbarungsinhalt der zugehörigen/beigefügten Prioritätsunterlagen (Abschrift der Voranmeldung) vollinhaltlich mit einbezogen, auch zu dem Zweck, Merkmale dieser Unterlagen in Ansprüche vorliegender Anmeldung mit aufzunehmen.

## Patentansprüche

1. Vorrichtung zum Abscheiden kristalliner Schichten auf mindestens einem kristallinen Substrat, mit einer von mehreren Wandungsteilen (1, 2, 3, 4) gebildeten Prozesskammer (5), welche Wandungsteile (1, 2, 3, 4) elektrisch leitend sind und unter Ausbildung von Berührungskontakten (2', 2", 3', 3") aneinander stoßen, mit einem die Wandungsteile (1, 2, 3, 4) in sich aufnehmenden, aus einem elektrisch nicht leitenden Material bestehenden Reaktorgehäuse (6) und mit einer die Wandungsteile (1, 2, 3, 4) umgebenden RF-Heiz-Spule, **gekennzeichnet durch** ein zwischen dem Reaktorgehäuse (6) und der Wandungsteilen (1, 2, 3, 4) angeordnetes, einstückiges und massives Schirm-Heiz-Rohr (8), dessen Material derart elektrisch leitend ist, dass es von den von dem mittels der RF-Spule (7) erzeugten RF-Feld dort induzierten Wirbelströmen erwärmt wird und das RF-Feld in erheblichem Umfange dämpft und derart die Wandungsteilen (1, 2, 3, 4) umgibt, dass die Wandungsteile (1, 2, 3, 4) im Wesentlichen **durch** Wärmestrahlung aufgeheizt werden, wobei die Strahlungswärme vom Schirm-Heiz-Rohr (8) kommt.

2. Vorrichtung nach Anspruch 1, **dadurch gekennzeichnet, dass** das Heizrohr (8) aus Graphit besteht.

3. Vorrichtung nach einem der vorhergehenden Ansprüche, **dadurch gekennzeichnet, dass** die Prozesskammerwände (1, 2, 3, 4) aus mindestens zwei voneinander trennbaren Teilen besteht.

4. Vorrichtung nach einem der vorhergehenden Ansprüche, **dadurch gekennzeichnet, dass** die Prozesskammerwandung (1, 2, 3, 4) durch das Schirm-Heiz-Rohr (8) in dem Reaktorgehäuse (6) gehalten ist.

5. Vorrichtung nach Anspruch 4, **gekennzeichnet durch** im Eckbereich der Prozesskammerwandung (1, 2, 3, 4) angreifende Haltemittel (9, 10) des Schirm-Heiz-Rohres (8).

6. Vorrichtung nach Anspruch 5, **dadurch gekennzeichnet, dass** die Haltemittel (9, 10) Aussparungen oder Vorsprünge der Innenwandung des Schirm-Heiz-Rohres (8) sind.

7. Vorrichtung nach einem der vorhergehenden Ansprüche, **gekennzeichnet durch** zwischen der Prozesskammerwandung (1, 2, 3, 4) und dem Schirm-Heiz-Rohr (8) angeordneten Höhlungen (11,12).

8. Vorrichtung nach Anspruch 7, **gekennzeichnet durch** in die Höhlungen (11,12) einbringbare Kühlelemente.

9. Vorrichtung nach einem der vorhergehenden Ansprüche, **gekennzeichnet durch** eine der Bodenwandung der Prozesskammerwandung zugeordneten Ladeplatte (13) zur Aufnahme eines Substrates.

10. Vorrichtung nach einem der vorhergehenden Ansprüche, **dadurch gekennzeichnet, dass** die mit einer Handhabungseinrichtung oder dergleichen aus und in die Prozesskammer bringbare Ladeplatte (13) einen Substrathalter (15) trägt.

11. Vorrichtung nach einem der vorhergehenden Ansprüche, **dadurch gekennzeichnet, dass** ein Substrathalter (15) auf einen Gaspolster drehantreibbar ist.

12. Vorrichtung nach einem der Ansprüche 10 oder 11, **gekennzeichnet durch** eine dem Prozesskammerboden (4) zugeordnete Gaszuleitung, die im Bereich des Bodens in einer Stufe mündet, welche Stufe die Ladeplatte (13) aufnimmt, welche an ihrer Unterseite Abdichtmittel aufweist, um die Gasaustrittsöffnung der Gaszuleitung (16) derart abzudichten, dass der daraus austretende Gasstrom **durch** Durchlassöffnungen der Ladeplatte hindurchtreten kann, um die in einer Aussparung der Ladeplatte (13) einliegende, den Substrathalter haltende kreisscheibenförmige Platte (15) drehanzutreiben.

13. Vorrichtung nach einem der vorhergehenden Ansprüche, **gekennzeichnet durch** einen in der Prozesskammer durchgeführten CVD-Prozess, wobei insbesondere Elemente der III. und V. oder der II. und VI. Hauptgruppe kristallbildend abgeschieden werden.

14. Vorrichtung nach einem der vorhergehenden Ansprüche, **dadurch gekennzeichnet, dass** die Elemente der III. Hauptgruppe als Chloride und die Elemente der V. Hauptgruppe als Hybride zugeführt werden.

## Claims

1. A device for depositing crystalline layers on at least one crystalline substrate, comprising a process chamber (5) formed by a number of wall elements (1, 2, 3, 4), which wall elements (1, 2, 3, 4) are electrically conductive and engage against one another with touching contacts (2', 2", 3', 3") being formed, comprising a reactor housing (6), accommodating the wall elements (1, 2, 3, 4) and consisting of an electrically nonconductive material, and comprising an RF heating coil surrounding the process chamber wall elements (1, 2, 3, 4), **characterized by** a one-piece, solid shielding/heating tube (8), which is disposed between the reactor housing (6) and the wall elements (1, 2, 3, 4), the material of the tube being electrically conductive in such a way that the tube is heated by the eddy currents induced there by the RF field generated by means of the RF coil (7) and that the tube dampens the RF field to a considerable extent and surrounds the wall elements (1, 2, 3, 4) in such a way that the wall elements (1, 2, 3, 4) are heated up substantially by thermal radiation, the radiant heat coming from the shielding/heating tube (8).

2. A device according to Claim 1, **characterized in that** the heating tube (8) consists of graphite.

3. A device according to either of the preceding claims, **characterized in that** the process chamber walls (1, 2, 3, 4) comprise at least two parts that can be separated from each other.

4. A device according to any of the preceding claims, **characterized in that** the process chamber wall (1, 2, 3, 4) is held in the reactor housing (6) by the shielding/heating tube (8).

5. A device according to Claim 4, **characterized by** holding means (9, 10) for the shielding/heating tube (8) that act in the corner region of the process chamber wall (1, 2, 3, 4).

6. A device according to Claim 5, **characterized in that** the holding means (9, 10) are recesses or projections on the inner wall of the shielding/heating tube (8).

7. A device according to any of the preceding claims, **characterized by** cavities (11, 12) located between the process chamber wall (1, 2, 3, 4) and the shielding/heating tube (8).

8. A device according to Claim 7, **characterized by** cooling elements that can be introduced into the cavities (11, 12).

9. A device according to any of the preceding claims, **characterized by** a loading plate (13), which is associated with the bottom wall of the process chamber walling and is intended for receiving a substrate.

10. A device according to any of the preceding claims, **characterized in that** the loading plate (13), which can be introduced into the process chamber and removed from it by a handling device or the like, carries a substrate holder (15).

11. A device according to any of the preceding claims, **characterized in that** the substrate holder (15) can be rotationally driven on a gas cushion.

12. A device according to either of Claims 10 and 11, **characterized by** a gas supply line which is associated with the bottom (4) of the process chamber and opens out in a step in the region of the bottom, which step accommodates the loading plate (13), the loading plate having on its underside sealing means to seal the gas outlet opening of the gas supply line (16) in such a way that the gas stream emerging from it can pass into and through passages in the loading plate, in order to rotationally drive the circular disk-shaped plate (15) that lies in a recess in the loading plate (13) and holds the substrate holder.

13. A device according to any of the preceding claims, **characterized by** a CVD process carried out in the process chamber, in particular elements of the IIIrd and Vth or IInd and VIth main group being deposited in a crystal-forming manner.

14. A device according to any of the preceding claims, **characterized in that** the elements of the IIIrd main group are supplied as chlorides and the elements of the Vth main group are supplied as hydrides.

## Revendications

1. Dispositif de dépôt de couches cristallines sur au moins un substrat cristallin, ledit dispositif comportant une chambre de réaction (5) qui est formée de plusieurs pièces de paroi (1, 2, 3, 4), lesquelles pièces de paroi (1, 2, 3, 4) sont électriquement conductrices et sont disposées de façon jointive en formant des contacts (2, 2", 3', 3"), un boîtier de réacteur (6) en matériau électriquement non conducteur recevant les pièces de paroi (1, 2, 3, 4) et une bobine de chauffage RF entourant les pièces de paroi (1, 2, 3, 4), **caractérisé par** un tube de chauffage et de protection (8), massif et monobloc, qui est disposé entre le boîtier de réacteur (6) et les pièces de paroi (1, 2, 3, 4) et dont le matériau est électriquement conducteur de sorte qu'il est chauffé par des courants de Foucault induits ici par le champ RF généré par la bobine RF (7) et atténue le champ RF dans une très grande mesure, et entoure les pièces de paroi (1, 2, 3, 4) de sorte que les pièces de paroi (1, 2, 3, 4) sont chauffées essentiellement par rayonnement thermique, la chaleur de rayonnement provenant du tube de chauffage et de protection (8).

2. Dispositif selon la revendication 1, **caractérisé en ce que** le tube de chauffage (8) est en graphite.

3. Dispositif selon l'une des revendications précédentes, **caractérisé en ce que** les parois (1, 2, 3, 4) de la chambre de réaction sont constituées d'au moins deux pièces séparables l'une de l'autre.

4. Dispositif selon l'une des revendications précédentes, **caractérisé en ce que** la paroi (1, 2, 3, 4) de la chambre de réaction est maintenue dans le boîtier de réacteur (6) par le tube de chauffage et de protection (8).

5. Dispositif selon la revendication 4, **caractérisé par** des moyens de retenue (9, 10) du tube de chauffage et de protection (8), lesquels moyens agissent au niveau des coins de la paroi (1, 2, 3, 4) de la chambre de réaction.

6. Dispositif selon la revendication 5, **caractérisé en ce que** les moyens de retenue (9, 10) sont des évidements ou des saillies de la paroi intérieure du tube de chauffage et de protection (8).

7. Dispositif selon l'une des revendications précédentes, **caractérisé par** des cavités (11, 12) ménagées entre la paroi (1, 2, 3, 4) de la chambre de réaction et le tube de chauffage et de protection (8).

8. Dispositif selon la revendication 7, **caractérisé par** des éléments de refroidissement qui peuvent être introduits dans les cavités (11, 12).

9. Dispositif selon l'une des revendications précédentes, **caractérisé par** une plaque de chargement (13) associée à la paroi de fond de la chambre de réaction et destinée à recevoir un substrat.

10. Dispositif selon l'une des revendications précédentes, **caractérisé en ce que** la plaque de chargement (13), qui peut être extraite de la chambre de réaction, et introduite dans celle-ci, au moyen d'un dispositif de manipulation ou analogue, supporte un porte-substrat (15).

11. Dispositif selon l'une des revendications précédentes, **caractérisé en ce qu'**un porte-substrat (15) peut être entraîné en rotation sur un coussin d'air.

12. Dispositif selon l'une des revendications 10 ou 11, **caractérisé par** une amenée de gaz qui est associée au fond (4) de la chambre de réaction et qui débouche dans un gradin dans la région du fond, lequel gradin qui reçoit la plaque de chargement (13) qui présente sur son côté inférieur des moyens d'étanchéité pour rendre étanche l'ouverture de sortie de gaz de l'amenée de gaz (16) de sorte que le flux de gaz qui en sort peut passer à travers des ouvertures de passage de la plaque de chargement pour entraîner en rotation la plaque (15), en forme de disque circulaire, qui est logée dans un évidement de la plaque de chargement (13) et qui maintient le porte-substrat.

13. Dispositif selon l'une des revendications précédentes, **caractérisé par** un procédé CVD mis en oeuvre dans la chambre de réaction, des éléments notamment des groupes principaux III et V ou des groupes principaux II et VI étant déposés en formant un cristal.

14. Dispositif selon l'une des revendications précédentes, **caractérisé en ce que** les éléments du groupe principal III sont amenés sous forme de chlorure et les éléments du groupe principal V sont amenés sous forme d'hybrides.
